# EUROPÄISCHE PATENTSCHRIFT

(11) **EP 0 942 638 B1**
(45) Veröffentlichungstag und Bekanntmachung des Hinweises auf die Patenterteilung: **07.05.2003**
(21) Anmeldenummer: 99101953.0
(22) Anmeldetag: 30.01.1999
(51) Int. Cl.: H05K 7/20, H05K 5/02, H02B 1/56

(54) **Belüftbares Gehäuse**
Ventilated housing
Boîtier ventilé

(30) Priorität: 13.03.1998 DE 19810945
(43) Veröffentlichungstag der Anmeldung: 15.09.1999
(73) Patentinhaber: Schroff GmbH, D-75334 Straubenhardt (DE)
(72) Erfinder: Schwenk, Hans-Martin, 75334 Straubenhardt (DE); Kempf, Heinz, 75365 Calw-Altburg (DE); Takats, Peter, 76337 Waldbronn (DE)
(74) Vertreter: Durm, Klaus, Dr.-Ing.

(56) Entgegenhaltungen:
- DE-A- 19 623 677
- DE-C- 348 794
- DE-U- 29 519 260
- DE-U- 29 609 776
- US-A- 4 618 071
- US-A- 5 646 823

## Beschreibung

Die Erfindung betrifft ein belüftbares Gehäuse zur Aufnahme elektrischer und elektronischer Komponenten, mit einer Innenwandung und mit einer Außenwandung, mit einer Eintrittsöffnung für die Frischluft, die in den Zischenraum zwischen der Innenwandung und der Außenwandung führt, mit einer Austrittsöffnung für die Abluft aus dem Zwischenraum, mit einer Lüftungsöffnung sowie mit einem Luftfilter für die Frischluft.

Gehäuse und Geräteschränke für elektrische und elektronische Geräte, die doppelte Wände aufweisen, sind bekannt. Solche Schränke sind vorzugsweise für den Außeneinsatz vorgesehen, wo sie dauerhaft einen störungsarmen Betrieb der eingebauten elektrischen und elektronischen Systeme bei variablen Außenbedingungen gewährleisten sollen. Die Abfuhr der Verlustwärme der Komponenten erfolgt in einfacher Weise durch die Anwendung des Kamineffektes bei der konstruktiven Gestaltung der Schränke (DE 348 794, DE 295 19 260, EP-A-0 810 704).

Um das Eindringen von Luftverschmutzungen wie Staub, Fremdkörper, Insekten etc. in das Gehäuseinnere zu verhindern, was zu Betriebsstörungen führen kann, sind Luftfilter unumgänglich (DE 196 23 677).

Die Luftfilter dürfen allerdings die Thermik in dem für die Luftführung vorgesehenen Zwischenraum zwischen der äußeren und der inneren Hülle des Gehäuses nicht behindern. Diese Forderung kann nur erfüllt werden, wenn die Filterflächen groß genug ausgelegt werden, um Luftstauungen zu vermeiden.

Auch belüftbare Gehäuse bzw. Schränke sind hinsichtlich ihrer Außenabmessungen Normen unterworfen und auch ihre Innenmaße müssen so gewählt sein, daß sie den Einbau normgerechter Komponenten etwa in Gestalt von Baugruppen oder Baugruppenträgern, problemlos gestatten. Der zum Einbau von größeren Filterflächen zur Verfügung stehende Raum im Gehäuse ist daher meistens sehr beschränkt, eine Vergrößerung des Zwischenraumes stößt schnell an Grenzen.

Die Aufgabe der Erfindung besteht in der Konzeption eines Luftfilters, welcher trotz großer Filterfläche nur wenig Platz für seinen Einbau im Gehäuse benötigt.

Zur Lösung der Aufgabe wird von einem doppelwandigen, belüftbaren Gehäuse der oben erwähnten Bauart ausgegangen. Die Aufgabe wird gelöst durch folgende technische Merkmale: Die Lüftungsöffnung befindet sich in der Innenwand, das Luftfilter sitzt vor der Lüftungsöffnung im Zwischenraum, als Luftfilter dient ein Filtereinsatz, der Filtereinsatz umgibt die Lüftungsöffnung und ist zwischen Innenwandung und Außenwandung eingeklemmt.

Bei dem vorgeschlagenen Luftfilter bestimmt der gewählte Durchmesser des zylindrischen Filtereinsatzes entscheidend die Größe der Filterfläche, welche der Mantelfläche des Einsatzes entspricht. Dieser Durchmesser darf die Weite der Lüftungsöffnung überschreiten, woraus eine große wirksame Oberfläche für das Luftfilter resultiert.

Es ist vorteilhaft, wenn der Filtereinsatz die Form eines zylindrischen Rohrstutzens besitzt, der mit seinen Rändern zwischen die Innenwandung und die Außenwandung dichtend eingeklemmt ist.

Eine Weiterbildung der Erfindung ist ein zylindrisches Stützgitter, auf welches der Filtereinsatz aufgeschoben ist. Dieses Stützgitter stabilisiert die Lage des Filtereinsatzes auch bei Ausbildung eines gewissen Unterdruckes vor der Lüftungsöffnung.

Zweckmäßig ist das Stützgitter an einem Montagering angeordnet, der lösbar am Rande der Lüftungsöffnung befestigt ist.

Damit der Filtereinsatz leicht ausgewechselt werden kann, ist gegenüber der Lüftungsöffnung an der Außenwand eine durch einen lösbaren Deckel verschlossene Service-Öffnung vorgesehen, deren lichte Weite größer ist als der Außendurchmesser des Montageringes.

Zweckmäßig trägt das Stützgitter ein abnehmbares, kreisförmiges Schutzgitter. Diese Maßnahme gewährleistet, daß beim Austausch des Filtereinsatzes nicht etwa unbeabsichtigt durch die Lüftungsöffnung hindurch in den Innenraum des Gehäuses hineingegriffen werden kann.

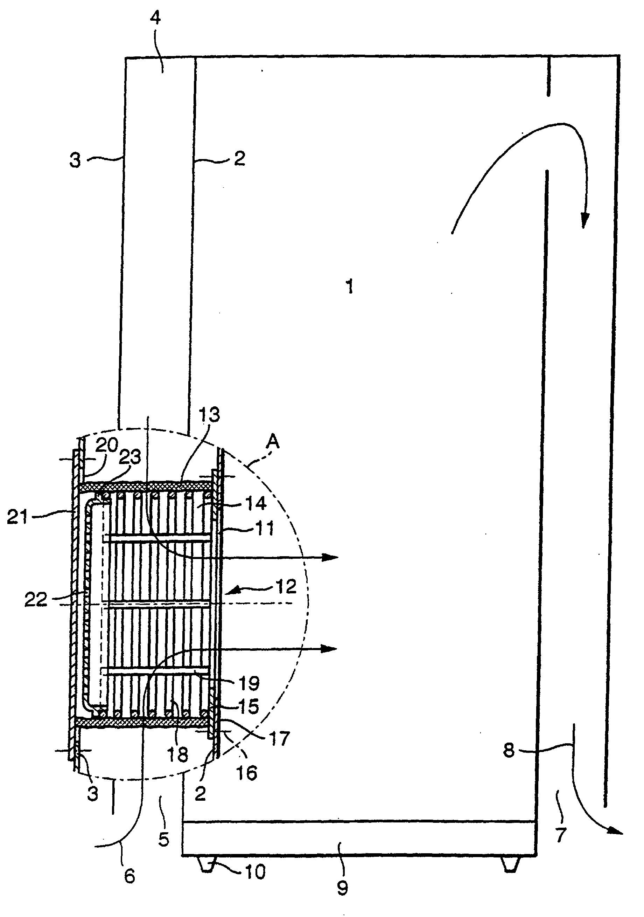

In der Zeichnung ist die Erfindung vereinfacht und schematisch wiedergegeben und wird nachfolgend in ihren Einzelheiten erläutert. Die Filteranordnung ist dabei in einem vergrößerten Maßstab innerhalb des mit Strichlinien A angegebenen Bereiches dargestellt.

Das belüftbare Gehäuse 1 ist zum Einbau von elektrischen und elektronischen Komponenten vorgesehen und wird vorwiegend im Freien eingesetzt.

Das Gehäuse 1 ist doppelwandig ausgebildet und es besitzt eine Innenwandung 2 und eine Außenwandung 3, die aus korrosionsgeschütztem Stahlblech hergestellt sind. Zwischen Innenwandung 2 und Außenwandung 3 ist ein Zwischenraum 4 gebildet, der für Belüftungsmaßnahmen vorgesehen ist.

Eine Eintrittsöffnung 5 für die von außen eintretende Frischluft 6 führt in den Zwischenraum 4 zwischen der Innenwandung 2 und der Außenwandung 3. Eine Austrittsöffnung 7 für die erwärmte Abluft 8 befindet sich der Eintrittsöffnung 5 gegenüber, beide liegen im Bereich des Sockels 9 des auf Füßen 10 stehenden Gehäuses 1. Die Bewegung der Luft im Gehäuse 1 wird durch den Kamineffekt des Zwischenraumes 4 bewirkt, sie kann aber auch durch eine Zwangsbelüftung geschehen.

Eine in den Innenraum des Gehäuses 1 führende Lüftungsöffnung 11 befindet sich oberhalb des Sockels 9 in der Innenwandung 2. Vor dieser Lüftungsöffnung 11 sitzt im Zwischenraum 4 ein Luftfilter 12.

Als Luftfilter 12 dient ein Filtereinsatz 13, der die Form eines kurzen, zylindrischen und dünnwandigen Rohrstutzens besitzt. Der Filtereinsatz 13 besteht aus einem luftdurchlässigen, filzartigen Textilmaterial oder aus einem Filterpapier.

Der Filtereinsatz 13 ist so im Zwischenraum 4 angeordnet, daß er die Lüftungsöffnung 11 zentrisch umgibt und zwischen Innenwandung 2 und Außenwandung 3 eingeklemmt ist.

Der Filtereinsatz 13 sitzt auf einem zylindrischen Stützgitter 14 und ist auf dieses aufgeschoben. Das Stützgitter 14 ist an einem flachen Montagering 15 befestigt, der lösbar unter Verwendung von Schraubverbindungen 16 am Rand 17 der Lüftungsöffnung 11 befestigt ist.

Das Stützgitter 14 besteht aus mehreren, nebeneinanderliegenden Ringen 18 gleichen Durchmessers und von kreisförmigem Querschnitt aus einem oberflächengeschützten Material, beispielsweise aus nicht rostendem Stahl. Die Ringe 18 werden von Stäben 19 im Abstand voneinander gehalten, die am Montagering 15 befestigt sind.

An der Außenwandung 3 des Gehäuses 1 ist eine Service-Öffnung vorgesehen, die durch einen lösbaren Deckel 21 verschlossen ist. Sie ermöglicht problemlos den Ausbau des Luftfilters 12 und den Austausch des Filtereinsatzes 13. Die Service-Öffnung 20 und der Montagering 15 sind kreisförmig, wobei die lichte Weite der Service-Öffnung 20 größer als der Außendurchmesser des Montageringes 15 ist.

Das Stützgitter 14 trägt ein kreisförmiges Schutzgitter 22, welches mit einem hochstehenden Ringrand 23 in das Stützgitter 14 eingesteckt ist. Dieses Schutzgitter 22 steht dicht unterhalb des Deckels 21 der Service-Öffnung 20 und dient als Schutzmaßnahme gegen unbeabsichtigtes Hineingreifen in den Innenraum des Gehäuses beim Wechsel des Filtereinsatzes 13.

### Zusammenstellung der Bezugszeichen

- A: Strichlinien
- 1: Gehäuse
- 2: Innenwandung
- 3: Außenwandung
- 4: Zwischenraum
- 5: Eintrittsöffnung
- 6: Frischluft
- 7: Austrittsöffnung
- 8: Abluft
- 9: Sockel
- 10: Füße
- 11: Lüftungsöffnung
- 12: Luftfilter
- 13: Filtereinsatz
- 14: Stützgitter
- 15: Montagering
- 16: Schraubverbindung
- 17: Rand
- 18: Ring
- 19: Stab
- 20: Service-Öffnung
- 21: Deckel
- 22: Schutzgitter
- 23: Ringrand

## Patentansprüche

1. Belüftbares Gehäuse
- zur Aufnahme elektrischer und elektronischer Komponenten,
- mit einer Innenwandung und mit einer Außenwandung,
- mit einer Eintrittsöffnung für die Frischluft, die in den Zwischenraum zwischen der Innenwandung und der Außenwandung führt,
- mit einer Austrittsöffnung für die Abluft aus dem Zwischenraum,
- mit einer Lüftungsöffnung sowie mit einem Luftfilter für die Frischluft,
**gekennzeichnet durch** folgende Merkmale:
- die Lüftungsöffnung befindet sich in der Innenwandung (2)
- das Luftfilter (12) sitzt im Zwischenraum (4) vor der Lüftungsöffnung (11)
- als Luftfilter (12) dient ein Filtereinsatz (13)
- der Filtereinsatz (13) umgibt die Lüftungsöffnung (11)
- der Filtereinsatz (13) ist zwischen Innenwandung (2) und Außenwandung (3) eingeklemmt.

2. Belüftbares Gehäuse nach Anspruch 1, **dadurch gekennzeichnet, daß** der Filtereinsatz (13) die Form eines kurzen, zylindrischen Rohrstutzens besitzt.

3. Belüftbares Gehäuse nach Anspruch 1 und 2, **gekennzeichnet durch** ein zylindrisches Stützgitter (14), auf welches der Filtereinsatz (13) aufgeschoben ist.

4. Belüftbares Gehäuse nach einem der Ansprüche 1 bis 3, **dadurch gekennzeichnet, daß** das Stützgitter (14) an einem Montagering (15) angeordnet ist, der lösbar am Rand der Lüftungsöffnung (11) befestigt ist.

5. Belüftbares Gehäuse nach einem der Ansprüche 1 bis 4, **dadurch gekennzeichnet, daß** gegenüber der Lüftungsöffnung (11) an der Außenwandung (3) eine durch einen lösbaren Deckel (21) verschlossene Service-Öffnung (20), vorgesehen ist, deren lichte Weite größer ist als der Außendurchmesser des Montageringes (15).

6. Belüftbares Gehäuse nach einem der Ansprüche 3 bis 5, **dadurch gekennzeichnet, daß** das Stützgitter (14) ein abnehmbares, kreisförmiges Schutzgitter (22) trägt.

## Claims

1. A ventilatable housing
- for receiving electrical and electronic components,
- with an inner wall,
- with an outer wall,
- with fresh air inlet opening, which leads into the intermediate space between the inner wall and the outer wall,
- with an outlet opening for used air to exit the intermediate space,
- with a ventilation opening as well as with an air filter for fresh air,
**characterised by** the following features:
- the ventilation opening is disposed in the inner wall (2)
- the air filter (12) is seated in the intermediate space (4) in front of the ventilation opening (11)
- a filter unit (13) serves as the air filter (12)
- the filter unit (13) surrounds the ventilation opening (11)
- the filter unit (13) is wedged in between the inner wall (2) and the outer wall (3).

2. A ventilatable housing according to claim 1 **characterised in that** the filter unit (13) has the shape of a short, cylindrical pipe stub.

3. A ventilatable housing according to claims 1 and 2 **characterised by** a cylindrical support screen (14) pushed onto the filter unit (13).

4. A ventilatable housing according to one of claims 1 to 3 **characterised in that** the support screen (14) is arranged at a mounting ring (15) that is releaseably secured to the edge of the ventilation opening (11).

5. A veritilatable housing according to one of claims 1 to 4 **characterised in that** opposite the ventilation opening (11) a service opening (20) is provided at the outer wall (3) and is closed by a releaseable cover (21), the inner width of the service opening being greater than the outer diameter of the mounting ring (15).

6. A ventilatable housing according to one of claims 3 to 5 **characterised in that** the support screen (14) carries a removable, circular protective grill (22).

## Revendications

1. Boîtier ventilé
- pour recevoir des composants électriques et électroniques,
- présentant une paroi intérieure et une paroi extérieure,
- un orifice d'entrée pour l'air frais qui mène à l'espace intermédiaire entre la paroi intérieure et la paroi extérieure,
- un orifice de sortie pour l'air vicié provenant de l'espace intermédiaire,
- un orifice de ventilation ainsi qu'un filtre à air pour l'air frais,
**caractérisé par** les particularités suivantes :
- l'orifice de ventilation se situe dans la paroi intérieure (2)
- le filtre à air (12) repose dans l'espace intermédiaire (4) devant l'orifice de ventilation (11)
- une cartouche de filtre (13) sert de filtre à air (12)
- la cartouche de filtre (13) entoure l'orifice de ventilation (11)
- la cartouche de filtre (13) est bridée entre la paroi intérieure (2) et la paroi extérieure (3).

2. Boîtier ventilé selon la revendication 1, **caractérisé en ce que** la cartouche de filtre (13) possède la forme d'une tubulure cylindrique courte.

3. Boîtier ventilé selon la revendication 1 et 2, **caractérisé par** une grille de support cylindrique (14), sur laquelle est glissée la cartouche de filtre (13).

4. Boîtier ventilé selon l'une des revendications 1 à 3, **caractérisé en ce que** la grille de support (14) est disposée sur un anneau de montage (15), qui est fixé de manière détachable au bord de l'orifice de ventilation (11).

5. Boîtier ventilé selon l'une des revendications 1 à 4, **caractérisé en ce qu'**en regard de l'orifice de ventilation (11) est prévue sur la paroi extérieure (3) une trappe de visite (20) dont la largeur est supérieure au diamètre extérieur de l'anneau de montage (15), fermée par un couvercle (21) détachable.

6. Boîtier ventilé selon l'une des revendications 3 à 5, **caractérisé en ce que** la grille de support (14) porte une grille de protection (22) circulaire amovible.
